# FASCICULE DE BREVET EUROPEEN

(11) **EP 0 410 853 B1**
(45) Date de publication et mention de la délivrance du brevet: **05.05.1993**
(21) Numéro de dépôt: 90402086.4
(22) Date de dépôt: 20.07.1990
(51) Int. Cl.: H02P 5/168, H03K 17/14, B60H 1/00, G05F 1/56, H02M 1/08

(54) **Commande de moteur par mos de puissance à travers un miroir de courant**
Leistungsmos Motorsteuerung mit Stromspiegelschaltung
Power mos motor control with current mirror

(30) Priorité: 26.07.1989 FR 8910040
(43) Date de publication de la demande: 30.01.1991
(73) Titulaire: VALEO ELECTRONIQUE, 78960 Voisins-Le-Bretonneux (FR)
(72) Inventeur: Tardif, François, F-75014 Paris (FR)
(74) Mandataire: Gamonal, Didier

(56) Documents cités:
- DE-A- 3 021 890
- US-A- 4 272 709
- PATENT ABSTRACTS OF JAPAN vol. 13, no. 22 (M-786)(3370) 19 janvier 1989, & JP-A-63 235114 (CALSONIC CORP.) 30 septembre 1988,
- PATENT ABSTRACTS OF JAPAN vol. 13, no. 23 (E-705)(3371) 19 janvier 1989, & JP-A-63 227215 (TOSHIBA CORP.) 21 septembre 1988,
- PATENT ABSTRACTS OF JAPAN vol. 12, no. 3 (E-570)(2850) 07 janvier 1988, & JP-A-62 163563 (TOSHIBA CORP.) 20 juillet 1987,
- PATENT ABSTRACTS OF JAPAN vol. 12, no. 452 (E-687)(3299) 28 novembre 1988, & JP-A-63 179621 (HITACHI LTD.) 23 juillet 1988,

## Description

L'invention concerne un circuit de commande de variation de la puissance appliquée à un organe électrique de puissance tel que par exemple un moteur électrique ou éventuellement un haut-parleur de forte puissance.

Dans certaines applications on a besoin de pouvoir faire varier continûment la puissance appliquée à un organe électrique. C'est le cas par exemple pour un moteur entraînant un ventilateur dont on veut pouvoir régler le débit d'air soufflé; une application particulière à laquelle la présente invention se prête très bien est la commande du pulseur d'air d'un système de conditionnement d'air de l'habitacle d'un véhicule; l'invention s'applique aussi généralement bien à la commande de moteurs de ventilateurs, le circuit de commande étant alors placé dans le flux d'air soufflé par le ventilateur pour bénéficier d'un refroidissement plus efficace.

Pour ce type d'application, on veut un circuit de commande particulièrement simple, fiable, ne nécessitant pas de dispositifs annexes coûteux, et ne nécessitant pas de réglage en usine pour ajuster le fonctionnement en fonction de la dispersion de fabrication des caractéristiques des composants utilisés.

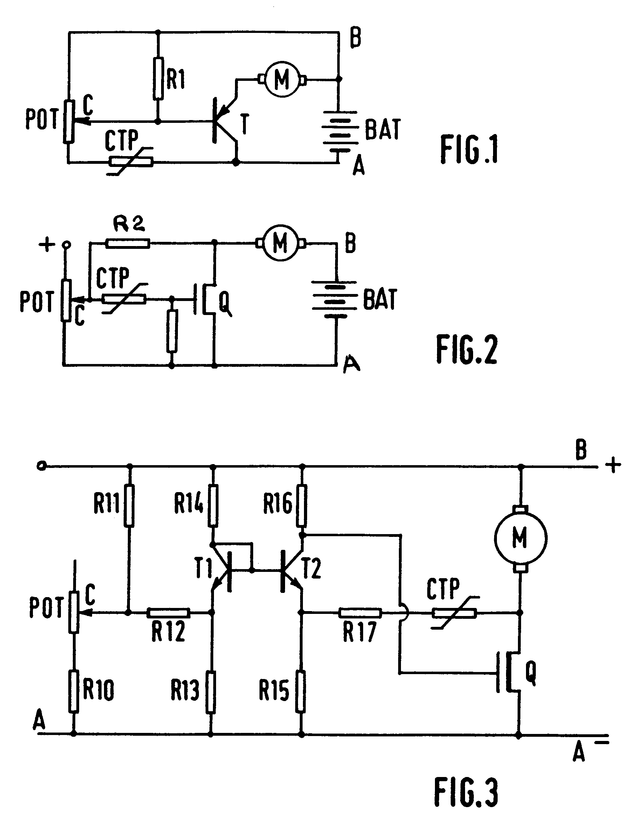

Un circuit de commande déjà utilisé pour la commande continue de moteurs électriques est représenté à la figure 1. Il comprend un transistor bipolaire de puissance T placé en série avec le moteur M, le tout étant alimenté entre les bornes A et B d'une batterie d'accumulateurs BAT. La commande se fait par un potentiomètre POT accessible sur le tableau de bord du véhicule (dans une application sur véhicule) et monté électriquement dans le circuit de polarisation de la base du transistor. Selon le réglage du potentiomètre, le transistor absorbe une partie plus ou moins grande de la tension fournie par la batterie. On règle ainsi la tension aux bornes du moteur donc sa vitesse et le débit d'air. Il s'agit d'un montage avec transistor "ballast", c'est-à-dire un transistor en série avec le moteur à commander, ce transistor absorbant une partie importante de la puissance fournie par la batterie. Le défaut de ces circuits, lié au fait que le transistor est un transistor bipolaire, est la tension non négligeable qui subsiste aux bornes du transistor lorsque la puissance maximale est demandée au moteur. On ne descend pas au dessous de 2,5 volts, d'où une perte de puissance importante par rapport à ce que le moteur serait capable de fournir.

Il existe aussi des circuits semblables, auxquels on rajoute un relais susceptible de court-circuiter le transistor lorsque la puissance maximale est demandée au circuit. L'inconvénient réside dans la complexité et le coût accru du circuit, auquel il faut ajouter une diminution de fiabilité due notamment à la présence du relais (sensible à l'humidité). D'autre part, l'utilisateur qui dispose d'une commande de puissance continue ressent désagréablement le saut de puissance qui se produit brusquement en fin de course de son potentiomètre de réglage, lorsque le relais de court-circuit se ferme.

Dans une autre solution essayée par la Demanderesse, on utilise comme transistor ballast un transistor à effet de champ dont la tension drain-source peut descendre à moins de 1 volt lorsqu'il est saturé, de sorte qu'on limite la puissance perdue dans le transistor pour la puissance maximale fournie au moteur (voir aussi JP-A-63 23 5114)

La figure 2 représente le schéma correspondant. La grille de commande du transistor à effet de champ Q est alimentée par une tension continue issue essentiellement du curseur d'un potentiomètre POT dont les bornes extrêmes sont alimentées par une différence de potentiel qui peut être prélevée aux bornes A et B de la batterie.

Pour limiter l'influence de la dispersion des caractéristiques des transistors à effet de champ, tout particulièrement sur les variations de courant en fonction de la tension grille-source Vgs, on utilise dans le schéma de la figure 2 une résistance de contre réaction connectée entre le drain et la grille du transistor. Dans l'exemple représenté, la résistance de contre réaction est en réalité décomposée en une résistance fixe R2, reliée au drain du transistor, en série avec une thermistance CTP de protection contre les surcharges thermiques; cette thermistance est fixée sur le transistor; elle est à coefficient de température positif. Dans le schéma électrique, elle est insérée entre le curseur C du potentiomètre et la grille de commande du transistor Q.

Cependant, on s'est aperçu que ce circuit ne fonctionnait pas d'une manière suffisamment indépendante des dispersions de caractéristiques du transistor Q.

La présente invention a pour but de proposer un schéma de circuit de commande simple et qui offre une plus grande indépendance de fonctionnement vis-à-vis des dispersions de caractéristiques du transistor Q; de plus, la présente invention vise à proposer un schéma qui soit immédiatement interchangeable avec un schéma à transistor bipolaire du type de celui de la figure 1, c'est-à-dire tel qu'on puisse brancher soit un circuit à transistor bipolaire soit le circuit selon l'invention entre le potentiomètre de réglage POT et le moteur M, sans aucune modification de fonctionnement.

Selon l'invention, on propose un circuit de commande d'un moteur électrique, comprenant un transistor à effet de champ de puissance ayant une source, un drain, et une grille de commande, ce transistor étant connecté en série avec le moteur entre deux bornes d'alimentation électrique, caractérisé en ce qu'il comprend deux transistors montés en miroir de courant l'un par rapport à l'autre de sorte que le second transistor recopie le courant circulant dans le premier, le premier transistor ayant son émetteur relié au curseur d'un potentiomètre de réglage, le second transistor ayant son collecteur relié à la grille du transistor de puissance à effet de champ et ayant son émetteur relié directement ou indirectement au drain du transistor à effet de champ.

Le montage est tel que la tension sur le drain du transistor de puissance tend à suivre la tension sur le curseur du potentiomètre de réglage. Cet asservissement est indépendant des caractéristiques du transistor de puissance.

De préférence l'émetteur du second transistor est relié au drain du transistor à effet de champ de puissance par l'intermédiaire d'une thermistance. Cette thermistance a de préférence une borne directement connectée au drain du transistor de puissance. Elle sert à éviter les surcharges thermiques du transistor de puissance.

D'autres caractéristiques et avantages de l'invention apparaîtront à la lecture de la description détaillée qui suit et qui est faite en référence aux dessins annexés dans lesquels :
- la figure 1 déjà décrite représente un circuit de la technique antérieure, utilisant un transistor bipolaire de puissance;
- la figure 2 déjà décrite représente un circuit utilisant un transistor MOS de puissance;
- la figure 3 représente un circuit de commande selon l'invention;

Le circuit de la figure 3 comporte un transistor à effet de champ de puissance Q à canal N, dont la source est reliée à la borne négative d'alimentation A, et dont le drain est relié à une borne du moteur M à commander, l'autre borne du moteur étant reliée à l'autre borne d'alimentation B.

L'organe de commande du moteur est un potentiomètre ou une résistance variable POT dont une borne, constituée par un curseur C, sert à prélever une fraction de la tension d'alimentation présente entre les bornes A et B. Dans l'exemple représenté, la résistance variable est en série entre deux résistances fixes R10 et R11 dont l'une est reliée à la borne d'alimentation A et l'autre à la borne positive d'alimentation B.

Le curseur C de la résistance variable est relié par une résistance R12 à l'émetteur d'un premier transistor T1 d'un ensemble de deux transistors T1 et T2 montés en miroir de courant l'un par rapport à l'autre.

Le transistor T2 est monté de manière à recopier (avec ou sans coefficient multiplicateur) le courant dans le transistor T2.

Plus précisément, l'émetteur du transistor T1 est relié à une résistance R13 reliée par ailleurs à la borne A; le collecteur du transistor T1 est relié à une résistance R14 reliée par ailleurs à la borne B. De même, l'émetteur du transistor T2 est relié à une résistance R15 reliée par ailleurs à la borne A et le collecteur de ce transistor T2 est relié par une résistance R16 à la borne B. Le rapport entre les résistances R15 et R13 définit le coefficient multiplicateur de la recopie de courant.

Le transistor T1 est monté en diode, c'est-à-dire que son collecteur est relié à sa base; il pourrait d'ailleurs à la rigueur être remplacé par une diode.

L'émetteur du transistor T2 est relié, à travers un ensemble série d'une résistance R17 et d'une thermistance à coefficient de température positif CTP, au drain du transistor à effet de champ Q.

Enfin, le collecteur du transistor T2 est relié à la grille du transistor de puissance Q.

Le miroir de courant constitué par les transistors T1 et T2 et les résistances qui leur sont adjointes fonctionne comme un amplificateur différentiel dont une entrée serait reliée au curseur C et dont l'autre entrée serait reliée au drain du transistor à effet de champ, la sortie de cet amplificateur différentiel étant prise sur le collecteur du transistor T2 pour attaquer la grille du transistor à effet de champ.

Ce montage en miroir de courant a pour fonction de ramener sur le drain du transistor à effet de champ une tension égale à la tension présente sur le curseur C de la résistance variable. En effet, si les tensions en ces deux points sont inégales, il en résulte un déséquilibre de tensions sur les émetteurs des deux transistors T1 et T2 du miroir; par conséquent il en résulte une variation de tension sur le collecteur du transistor T2, donc une variation de la tension drain-grille du transistor à effet de champ, jusqu'à rétablissement de l'équilibre.

La tension drain-source du transistor Q, et par contrecoup la tension appliquée aux bornes du moteur suit donc les variations de tension du curseur C. Par comparaison, sur un schéma tel que celui de la figure 2, c'est la tension grille-source du transistor Q qui suit les variations de la tension aux bornes du curseur; mais la tension aux bornes du moteur dépend alors des caractéristiques du transistor.

Avec le schéma selon l'invention on aboutit à une bonne indépendance de fonctionnement par rapport aux dispersions de caractéristiques du transistor de puissance.

On notera que la thermistance CTP est reliée au drain du transistor à effet de champ de puissance. Comme c'est en général le drain du transistor de puissance qui sera relié électriquement au radiateur, on voit que la thermistance peut avoir une électrode directement collée sans isolation électrique sur ce radiateur, ce qui est très favorable.

## Revendications

1. Circuit de commande d'un moteur électrique, comprenant un transistor à effet de champ de puissance (Q) ayant une source, un drain, et une grille de commande, ce transistor étant connecté en série avec le moteur (M) entre deux bornes d'alimentation électrique (A et B), caractérisé en ce qu'il comprend deux transistors (T1, T2) montés en miroir de courant l'un par rapport à l'autre, de sorte que le second transistor (T2) recopie le courant circulant dans le premier (T1), le premier transistor ayant son émetteur relié au curseur d'un potentiomètre de réglage (POT), le second transistor ayant son collecteur relié à la grille du transistor de puissance à effet de champ et ayant son émetteur relié directement ou indirectement au drain du transistor à effet de champ.

2. Circuit de commande selon la revendication 1, caractérisé en ce que l'émetteur du second transistor est relié au drain du transistor à effet de champ de puissance par l'intermédiaire d'une thermistance.

3. Circuit de commande selon la revendication 2, caractérisé en ce que la thermistance a une borne directement connectée au drain du transistor de puissance.

## Patentansprüche

1. Steuerstromkreis eines Elektromotors, enthaltend einen Leistungsfeldeffekttransistor (Q) mit einer Source, einem Drain und einem Steuer-Gate, wobei dieser Transistor mit dem Motor (M) zwischen zwei Stromanschlußklemmen (A und B) in Serie geschaltet ist, **dadurch gekennzeichnet**, daß er zwei Transistoren (T1, T2) enthält, die zueinander in Stromspiegelschaltung geschaltet sind, so daß der zweite Transistor (T2) den im ersten (T1) zirkulierenden Strom wiedergibt, während der erste Transistor mit seinem Emitter an den Schleifkontakt eines Regelpotentiometers (POT) angeschlossen ist, wobei der zweite Transistor mit seinem Kollektor an das Gate des Feldeffektleistungstransistors und mit seinem Emitter direkt oder indirekt an den Drain des Feldeffekttransistors angeschlossen ist.

2. Steuerstromkreis nach Anspruch 1, **dadurch gekennzeichnet,** daß der Emitter des zweiten Transistors mit dem Drain des Leistungsfeldeffekttransistors über einen Thermistor angeschlossen ist.

3. Steuerstromkreis nach Anspruch 1, **dadurch gekennzeichnet**, daß der Thermistor mit einer Klemme direkt an den Drain des Leistungstransistors angeschlossen ist.

## Claims

1. A control circuit for an electric motor, comprising a field effect power transistor (Q) having a source, a drain, and a control gate, the said transistor being connected in series with the motor (M) between two electrical supply terminals (A and B), characterised in that it includes two transistors (T1, T2), mounted in back-to-back current relationship with each other in such a way that the second transistor (T2) replicates the current flowing in the first transistor (T1), the first transistor having its emitter connected to the cursor of an adjusting potentiometer (POT), the second transistor having its collector connected to the gate of the field effect power transistor and having its emitter connected directly or indirectly to the drain of the field effect transistor.

2. A control circuit according to Claim 1, characterised in that the emitter of the second transistor is connected to the drain of the field effect power transistor through a thermistor.

3. A control circuit according to Claim 2, characterised in that the thermistor has one terminal directly connected to the drain of the power transistor.
